Europäisches Patentamt

European Patent Office

Office européen des brevets

(11) Numéro de publication : **0 308 287 B1**

(12) **FASCICULE DE BREVET EUROPEEN**

(19)

(45) Date de publication du fascicule du brevet :
**08.04.92 Bulletin 92/15**

(21) Numéro de dépôt : **88402159.3**

(22) Date de dépôt : **25.08.88**

(51) Int. Cl.⁵ : **H03H 19/00**

(73) Titulaire : **ETAT FRANCAIS représenté par le Ministre Délégué des Postes et Télécommunications (CENTRE NATIONAL D'ETUDES DES TELECOMMUNICATIONS) 38-40 rue du Général Leclerc F-92131 Issy-les-Moulineaux (FR)**
Titulaire : **Mulawka, Jan ul. Bernardynska 3-M 41 PL-02904 Warszawa (PL)**

(72) Inventeur : **Mulawka, Jan ul. Bernardynska, 3-M41 PL-02904 Warszawa (PL)**
Inventeur : **Agnieszka, Konczykowska 9bis Chemin du Tennis F-92240 L'Haye les Roses (FR)**
Inventeur : **Bon, Michel 4 Allée des Alouettes F-91370 Verrières le Buisson (FR)**

(74) Mandataire : **Mongrédien, André et al c/o BREVATOME 25, rue de Ponthieu F-75008 Paris (FR)**

(54) Cellule biquadratique à capacités commutées sans boucle continue de contre-réaction et à faible sensibilité par rapport au gain des amplificateurs opérationnels et au ratio des capacités.

(30) Priorité : **28.08.87 FR 8712028**

(43) Date de publication de la demande :
**22.03.89 Bulletin 89/12**

(45) Mention de la délivrance du brevet :
**08.04.92 Bulletin 92/15**

(84) Etats contractants désignés :
**DE GB**

(56) Documents cités :
**US-A- 4 623 854**
**IEEE PROCEEDINGS SECTION A à I, vol. 133, no. 3, partie G, juin 1986, pages 154-158, Stevenage, Herts, GB; A.E. SAID et al.: "Stray-free switched-capacitor general biquad blocks"**
**IEEE TRANSACTIONS ON CIRCUITS AND SYSTEMS, vol. CAS-33, no. 4, avril 1986, pages 458-460, IEEE, New York, US; P.V. ANANDA MOHAN et al.: "Parasitic-compensated single amplifier SC biquad equivalent to Fleischer-Laker SC biquad**
**ELECTRONICS LETTERS, vol. 20, no. 18, 30 août 1984, pages 7313, Staines, Middlesex, GB; S. Eriksson et al.: "Offset-compensated switched-capacitor leapfrog filters"**

EP 0 308 287 B1

## Description

La présente invention a pour objet une cellule biquadratique à capacités commutées sans boucle continue de contre-réaction.

L'invention concerne le traitement des signaux de la gamme vidéo, c'est-à-dire de signaux ayant une fréquence de quelques mégahertz.

Les cellules biquadratiques sont des filtres du second ordre. Pour la réalisation d'un filtre d'ordre n supérieur à 2, il suffit de mettre en cascade n/2 cellules biquadratiques, si n est pair ou (n-1)/2 cellules biquadratiques plus un filtre du premier ordre si n est impair.

Les cellules biquadratiques à capacités commutés sont apparues il y a une dizaine d'années dans la littérature scientifique et on donné lieu très rapidement à des applications industrielles en technologie MOS dans le domaine du traitement du signal de basse fréquence, essentiellement le spectre audio.

Plus récemment, l'accroissement des performances des amplificateurs opérationnels à permis l'utilisation des cellules biquadratiques à capacités commutées dans le domaine du traitement de signal vidéo (quelques mégahertz).

Les cellules biquadratiques à capacités commutées comprennent des amplificateurs opérationnels, des condensateurs et des interrupteurs. Dans un tel circuit, une résistance électrique est simulée par un condensateur et deux interrupteurs. La valeur de la résistance est de 1/fC, ou f est la fréquence de commutation des interrupteurs et C la capacité du condensateur. La fréquence du signal d'horloge de commutation des interrupteurs doit être environ 20 fois plus élevée que la fréquence du signal à traiter. Dans le domaine des cellules biquadratiques à capacités commutées de haute fréquence, les recherches s'orientent vers des circuits ayant une faible sensibilité par rapport au gain des amplificateurs opérationnels, car pour les applications dans le domaine haute fréquence, seuls des amplificateurs opérationnels simples et à gain relativement faible peuvent être utilisés.

Dans l'article A1, cité en annexe, il est proposé de réduire l'effet de gain fini en introduisant un tampon et trois interrupteurs dans une cellule biquadratique de type Fleischer-Laker, telle que décrite dans l'article A2.

Une telle cellule biquadratique n'est pas satisfaisante car elle comporte des éléments additionnels qui la rendent plus complexe.

Par ailleurs, la capacité totale des condensateurs est élevée, ce qui se traduit par une cellule biquadratique de taille importante sous forme intégrée.

On connaît également des intégrateurs à capacités commutées sans boucle continue de contre-réaction, qui permettent de minimiser l'influence de gain fini des amplificateurs. De tels intégrateurs sont décrits dans les articles A3, A4 et A5. L'utilisation de ces intégrateurs pour la réalisation d'un filtre nécessite l'introduction d'un amplificateur sommateur pour séparer les étages successifs du filtre, ou l'utilisation d'une horloge à trois phases.

Enfin, une cellule biquadratique sans boucle continue de contre-réaction est décrite dans l'article A6. Cette cellule biquadratique comprend deux amplificateurs opérationnels et de 9 à 15 condensateurs. La sensibilité de cette cellule biquadratique aux éléments passifs, c'est-à-dire la sensibilité par rapport à une variation des valeurs relatives des condensateurs, n'est pas contrôlée et peut être élevée. De même, la sensibilité par rapport au gain des amplificateurs opérationnels est assez forte.

L'invention a pour but de remédier aux inconvénients des cellules biquadratiques à capacités commutées connues. Elle a pour objet une cellule biquadratique sans boucle continue de contre-réaction ayant une faible sensibilité par rapport au gain des amplificateurs opérationnels, une faible sensibilité par rapport au ratio de capacité et une faible capacité totale.

L'invention a également pour objet une cellule biquadratique comprenant une pluralité de connexions d'entrée-sortie et permettant d'obtenir différentes fonctions de filtrage suivant le choix de la connexion d'entrée et de la connexion de sortie du signal à traiter.

L'invention a enfin pour objet une cellule biquadratique munie de commutateurs permettant de sélectionner, pour chaque fonction de filtrage, une configuration de circuit parmi une pluralité de configurations ayant des sensibilités différentes par rapport au gain des amplificateurs opérationnels et par rapport au ratio de capacité.

De manière précise, l'invention a pour objet une cellule biquadratique à capacités commutées comprenant six connexions d'entrée-sortie P1, P2, ..., P6, et une entrée d'horloge H pour recevoir un signal d'horloge pour commander la fermeture et l'ouverture d'un ensemble d'interrupteurs, lesdits interrupteurs comprenant une première famille d'interrupteurs qui sont commandés dans l'état ouvert pendant une première demi-période de chaque période du signal d'horloge et qui sont commandés dans l'état fermé pendant une seconde demi-période de chaque période du signal d'horloge, et une seconde famille d'interrupteurs qui sont commandés dans l'état fermé pendant ladite première demi-période de chaque période du signal d'horloge et dans l'état ouvert pendant ladite seconde demi-période de chaque période du signal d'horloge, ladite cellule biquadratique étant caractérisée en ce qu'il comprend :

– un premier amplificateur opérationnel OA1 muni d'une entrée non inverseuse reliée à la terre, d'une entrée inverseuse E1, et d'une sortie inverseuse S1 reliée à la première connexion P1 du filtre,

– un second amplificateur opérationnel OA2 muni d'une entrée non-inverseuse reliée à la terre, d'une entrée inverseuse E2, et d'une sortie S2 reliée à la deuxième connexion P2 du filtre,

– un premier condensateur C1 et des interrupteurs pour connecter ledit condensateur entre la sortie S1 du premier amplificateur opérationnel et l'entrée E2 du second amplificateur opérationnel pendant lesdites premières demi-périodes du signal d'horloge, et pour connecter ledit condensateur à la connexion P3 et à un noeud N1 pendant lesdites secondes demi-périodes du signal d'horloge,

– un deuxième condensateur C2 et des interrupteurs pour connecter ledit condensateur entre l'entrée E1 et la sortie S1 du premier amplificateur opérationnel pendant lesdites premières demi-périodes du signal d'horloge, et pour connecter ledit condensateur uniquement à l'entrée E1 du premier amplificateur opérationnel pendant lesdites secondes demi-périodes du signal d'horloge,

– un troisième condensateur C3 et des interrupteurs pour connecter ledit condensateur entre un noeud N2 et la connexion P4 pendant lesdites premières demi-périodes du signal d'horloge, et pour connecter ledit condensateur entre l'entrée E2 et la sortie S2 du second amplificateur opérationnel pendant lesdites secondes demi-périodes du signal d'horloge,

– un quatrième condensateur C4 et des interrupteurs pour connecter ledit condensateur entre un noeud N3 et la sortie S2 du second amplificateur opérationnel pendant lesdites premières demi-périodes du signal d'horloge, et pour connecter ledit condensateur entre l'entrée E2 et la sortie S2 du second amplificateur opérationnel pendant lesdites secondes demi-périodes du signal d'horloge,

– un cinquième condensateur C5 et des interrupteurs pour connecter ledit condensateur entre l'entrée E2 et la sortie S2 du second amplificateur opérationnel pendant lesdites premières demi-périodes du signal d'horloge, et pour connecter ledit condensateur uniquement à l'entrée E2 du second amplificateur opérationnel pendant lesdites secondes demi-périodes du signal d'horloge,

– un sixième condensateur C6 et des interrupteurs pour connecter ledit condensateur entre la connexion P6 et l'entrée E2 du second amplificateur opérationnel pendant lesdites premières demi-périodes du signal d'horloge, et pour connecter ledit condensateur entre la sortie S1 et l'entrée E1 du premier amplificateur opérationnel pendant lesdites secondes demi-périodes du signal d'horloge,

– un septième condensateur C7 et des interrupteurs pour connecter ledit condensateur entre l'entrée E1 du premier amplificateur opérationnel et un noeud N4 pendant lesdites premières demi-périodes du signal d'horloge, et pour connecter ledit condensateur entre l'entrée E1 du premier amplificateur opérationnel et la sortie S2 du second amplificateur opérationnel pendant lesdites secondes demi-périodes du signal d'horloge,

– un huitième condensateur C8 et des interrupteurs pour connecter ledit condensateur entre les connexions P5 et P6 pendant lesdites premières demi-périodes du signal d'horloge, et pour connecter ledit condensateur entre l'entrée E1 et la sortie S1 du premier amplificateur opérationnel pendant lesdites secondes demi-périodes du signal d'horloge, et

– quatre commutateurs à deux positions commandés par des signaux appliqués sur des bornes B1, B2, B3, B4 de la cellule biquadratique, le premier commutateur étant disposé pour relier le noeud N1 à l'entrée E2 du second amplificateur opérationnel ou à la terre, le deuxième commutateur étant disposé pour relier le noeud N2 à l'entrée E2 du second amplificateur opérationnel ou à la terre, le troisième commutateur étant disposé pour relier le noeud N3 à la sortie S1 du premier amplificateur opérationnel ou à la terre, et le quatrième commutateur étant disposé pour relier le noeud N4 à l'entrée E2 du second amplificateur opérationnel ou à la terre.

Cette cellule biquadratique permet de réaliser des filtres passe-bas, passe-bande ou passe-haut, selon les connexions choisies pour appliquer le signal à filtrer et pour recueillir le signal filtré.

Pour une fonction de filtrage déterminée, la sensibilité du filtre par rapport aux variations de gain des amplificateurs opérationnels et la sensibilité par rapport au ratio de capacité peut être choisie en commandant les commutateurs doubles.

Les caractéristiques et avantages de l'invention ressortiront mieux de la description qui va suivre, donnée à titre illustratif mais non limitatif, en référence aux dessins annexés, sur lesquels :

– la figure 1 représente schématiquement un mode de réalisation de la cellule biquadratique de l'invention,

– la figure 2 représente schématiquement une boucle de contre-réaction utilisée classiquement pour stabiliser un amplificateur opérationnel d'une cellule à capacités commutées sans boucle continue de contre-réaction,

– la figure 3 représente schématiquement une cellule biquadratique à faible sensibilité par rapport au gain des amplificateurs opérationnels, cette cellule correspondant à une première configuration de la cellule biquadratique de la figure 1,

– les figures 4a à 4c illustrent différents filtres obtenus selon les signaux appliqués sur les connexions d'entrée-sortie P1-P6 de la cellule biquadratique de la figure 3,

– la figure 5 représente schématiquement une cellule biquadratique ayant une faible sensibilité par rapport au ratio de capacité, cette cellule correspondant à une seconde configuration de la cellule biquadratique de la figure 1,

– les figures 6a à 6e illustrent différents filtres obtenus selon les signaux appliqués sur les connexions d'entrée-sortie P1-P6 de la cellule biquadratique de la figure 5,

– la figure 7 représente schématiquement une cellule constituant un compromis entre les cellules représentées sur les figures 3 et 5, cette cellule correspondant à une troisième configuration de la cellule représentée sur la figure 1,

– les figures 8a à 8d représentent différents filtres obtenus selon les signaux appliqués sur les connexions d'entrée-sortie P1-P6 de la cellule biquadratique de la figure 7, et

– les figures 9, 10, 11 sont des graphiques représentant respectivement le facteur de surtension Q, l'erreur relative sur le facteur de surtension $\Delta Q/Q$ et l'erreur relative $\Delta \omega_o / \omega_o$ -où $\omega_o$ est la pulsation correspondant à la fréquence centrale du signal à traiter- en fonction du gain A des amplificateurs opérationnels pour des cellules biquadratiques connues et des cellules biquadratiques selon l'invention.

La cellule biquadratique de l'invention est destinée notamment au traitement des signaux situés dans la gamme vidéo, c'est-à-dire ayant une fréquence centrale de l'ordre de quelques mégahertz. Une telle cellule biquadratique est réalisée avantageusement en technologie MESFET (DFET) sur GaAs, et le signal d'horloge de commande des interrupteurs a une fréquence de l'ordre de quelques centaines de mégahertz.

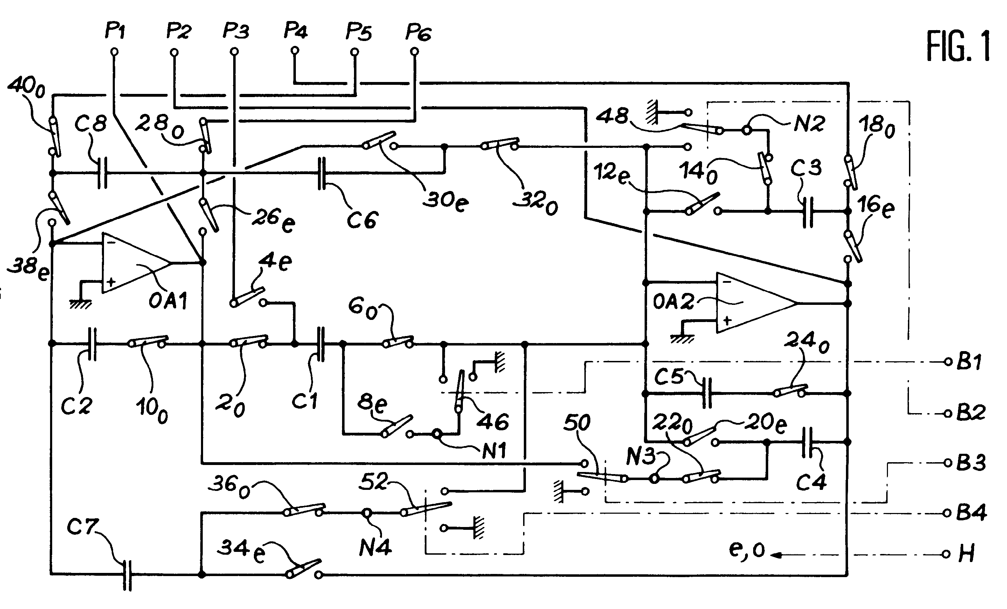

Un mode de réalisation de la cellule biquadratique de l'invention est représenté sur la figure 1. Cette cellule biquadratique comprend un premier amplificateur opérationnel OA1, un second amplificateur opérationnel OA2, huit condensateurs C1-C8, et des interrupteurs commandés par un signal d'horloge H. Ces interrupteurs comprennent une première famille d'interrupteurs, notés "e", qui sont ouverts pendant la première demi-période de chaque période du signal d'horloge et qui sont fermés pendant la seconde demi-période de chaque période du signal d'horloge, et une seconde famille d'interrupteurs, notés "o", qui sont fermés pendant la première demi-période de chaque période du signal d'horloge et qui sont ouverts pendant la seconde demi-période de chaque période du signal d'horloge.

La cellule biquadratique de l'invention est munie de six connexions d'entrée-sortie P1, P2, ..., P6 qui permettent de définir différentes fonctions de filtrage selon la connexion choisie pour appliquer le signal à filtrer et la connexion choisie pour recueillir le signal filtré.

Les amplificateurs opérationnels OA1, OA2 comprennent chacun une entrée inverseuse, une entrée non-inverseuse reliée à la terre, et une sortie. La sortie de l'amplificateur OA1 est reliée à la connexion P1 et la sortie de l'amplificateur OA2 est reliée à la connexion P2.

Le condensateur C1 a une extrémité reliée d'une part à la sortie de l'amplificateur opérationnel OA1 par l'intermédiaire d'un interrupteur $2_o$, et d'autre part à la connexion P3 par l'intermédiaire d'un interrupteur $4_e$, et une autre extrémité reliée d'une part à l'entrée inverseuse de l'amplificateur opérationnel OA2, par l'intermédiaire d'un interrupteur $6_o$ et d'autre part, à un noeud N1 par l'intermédiaire d'un interrupteur $8_e$. Le condensateur C2 a une extrémité reliée à l'entrée inverseuse de l'amplificateur opérationnel OA1 et une autre extrémité reliée, par un interrupteur $10_o$, à la sortie de l'amplificateur opérationnel OA1. Le condensateur C3 a une extrémité reliée d'une part à l'entrée inverseuse de l'amplificateur opérationnel OA2 par un interrupteur $12_e$ et d'autre part à un noeud N2 par un interrupteur $14_o$, et une deuxième extrémité reliée d'une part à la sortie de l'amplificateur opérationnel OA2 par un interrupteur $16_e$ et d'autre part à la connexion P4 par un interrupteur $18_o$. Le condensateur C4 a une extrémité reliée d'une part à l'entrée inverseuse de l'amplificateur opérationnel OA2 par un interrupteur $20_e$ et d'autre part à un noeud N3 par un interrupteur $22_o$, et une autre extrémité reliée à la sortie de l'amplificateur opérationnel OA2. Le condensateur C5 a une extrémité reliée à l'entrée inverseuse de l'amplificateur opérationnel OA2 et une autre extrémité reliée par un interrupteur $24_o$ à la sortie de l'amplificateur opérationnel OA2. Le condensateur C6 a une première extrémité reliée d'une part, à la sortie de l'amplificateur opérationnel OA1 par un interrupteur $26_e$ et d'autre part à la connexion P6 par un interrupteur $28_o$, et une deuxième extrémité reliée d'une part à l'entrée inverseuse dans l'amplificateur opérationnel OA1 par un interrupteur $30_e$ et d'autre part à l'entrée inverseuse de l'amplificateur opérationnel OA2 par un interrupteur $32_o$. Le condensateur C7 a une extrémité reliée à l'entrée inverseuse de l'amplificateur opérationnel OA1 et une autre extrémité reliée d'une part, à la sortie de l'amplificateur opérationnel OA2 par un interrupteur $34_e$ et d'autre part à un noeud N4 par un interrupteur $36_o$. Le condensateur C8 a une extrémité reliée d'une part à l'entrée inverseuse de l'amplificateur opérationnel OA1 par un interrupteur $38_e$ et d'autre part à la connexion P5 par un interrupteur $40_o$ et une autre extrémité reliée d'une part à la sortie de l'amplificateur opérationnel OA1 par

l'interrupteur 26$_e$ et d'autre part à la connexion P6 par l'interrupteur 28$_o$.

La cellule biquadratique de l'invention comprend en outre quatre commutateurs à deux positions qui permettent, pour chaque fonction de filtrage définie par un choix des connexions d'entrée et de sortie, d'obtenir différentes configurations de la cellule biquadratique qui se distinguent par leur sensibilité au gain des amplificateurs opérationnels et au ratio des capacités. L'état des commutateurs 46, 48, 50, 52 est commandé par des signaux appliqués sur des bornes B1, B2, B3, B4 de la cellule biquadratique.

Le commutateur 46 est disposé de manière à relier le noeud N1 à l'entrée inverseuse de l'amplificateur opérationnel OA2 ou à la terre ; le commutateur 48 est disposé de manière à relier le noeud N2 à l'entrée inverseuse de l'amplificateur opérationnel OA2 ou à la terre ; le commutateur 50 est disposé de manière à relier le noeud N3 à la sortie de l'amplificateur opérationnel OA1 ou à la terre; et, le commutateur 52 est disposé de manière à relier le noeud N4 à l'entrée inverseuse de l'amplificateur opérationnel OA2 ou à la terre.

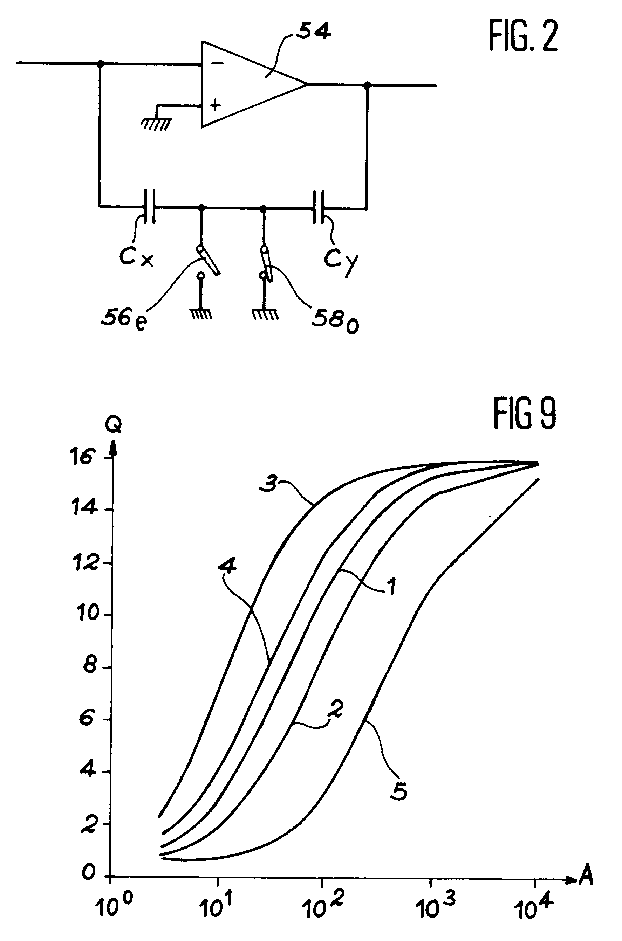

La cellule biquadratique de l'invention, dont un mode de réalisation est représenté schématiquement sur la figure 1, ne comporte pas de boucle continue de contre-réaction. Pour stabiliser les amplificateurs opérationnels, il est connu d'introduire sur chaque amplificateur opérationnel deux condensateurs de petite capacité qui créent une boucle de contre-réaction comme on l'a représentée schématiquement sur la figure 2.

Sur cette figure, un amplificateur opérationnel 54 comprend une boucle de contre-réaction constituée par un condensateur Cx et un condensateur Cy connectés en série. Deux interrupteurs 56$_e$ et 58$_o$ sont en outre disposés chacun entre le point commun des condensateurs et la terre. Cette boucle de contre-réaction est décrite notamment dans les articles A6 et A7.

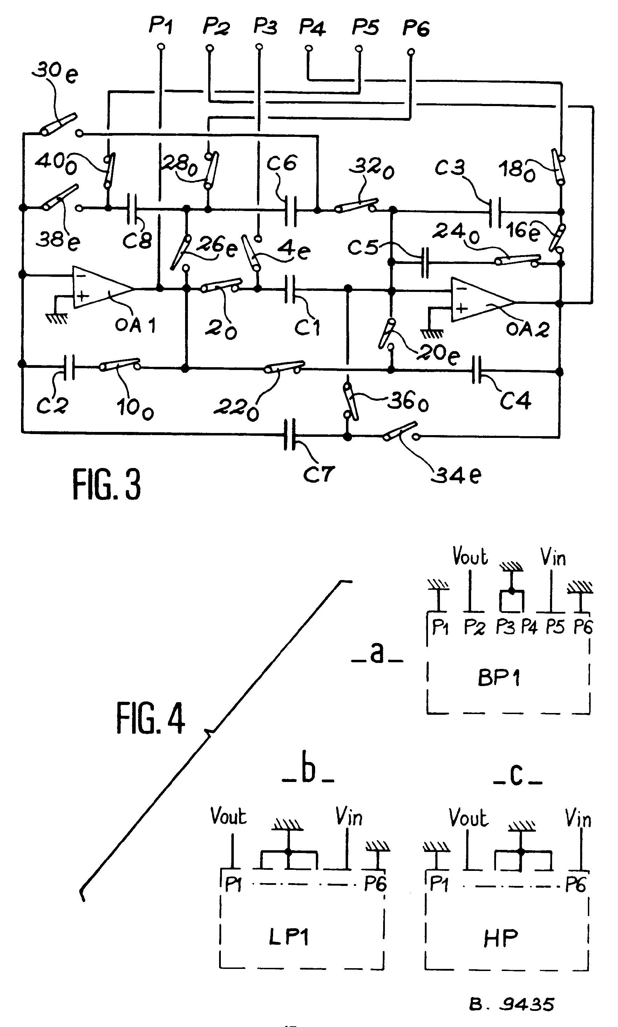

On a représenté sur la figure 3 un circuit équivalent à la cellule biquadratique représentée sur la figure 1 dans laquelle les commutateurs 46, 48 et 52 sont reliés à l'entrée inverseuse de l'amplificateur opérationnel OA2, et le commutateur 50 est relié à la sortie de l'amplificateur opérationnel OA1.

Dans cet état du commutateur 46, les interrupteurs 6$_o$ et 8$_e$ de la figure 1 permettent de relier en permanence le condensateur C1 à l'entrée inverseuse de l'amplificateur opérationnel OA2. De même, le commutateur 48 met en parallèle les interrupteurs 12$_e$ et 14$_o$, ce qui permet de relier en permanence le condensateur C3 à l'interrupteur 32$_o$.

La cellule biquadratique représentée sur la figure 3 possède la propriété d'être peu sensible aux variations de gain des amplificateurs opérationnels. Elle présente également de bonnes performances en ce qui concerne la capacité totale des condensateurs.

La cellule biquadratique représentée sur la figure 3 peut être utilisée pour réaliser différentes fonctions de filtrage, selon la connexion choisie pour appliquer le signal à filtrer et la connexion choisie pour recueillir le signal filtré.

Les figures 4a, 4b et 4c illustrent schématiquement l'état des connexions P1, P2, P3,..., P6, correspondant respectivement à un filtre passe-bande, un filtre passe-bas, et un filtre passe-haut.

Un filtre passe-bande BP1 est obtenu en appliquant le signal à filtrer $V_{in}$ sur la connexion P5 et en recueillant le signal filtré $V_{out}$ sur la connexion P2, les connexions P1, P3, P4, et P6 étant reliées à la terre. La fonction de transfert de ce filtre est égale à :

$$F_{BP1}(z) = \frac{N_{BP1}(z)}{D(z)}$$

$$\text{où } N_{BP1}(z) = -z^{-1}.(1-z^{-1}).C2.C6.C8.(C3 + C4)/W$$

$$\text{et } D(z) = 1 + z^{-1}\left[-2 + \frac{C4.C7.(C1.C6 + C2.C6 + C1.C8)}{W}\right] + z^{-2}(1 - \frac{C2.C4.C6.C7}{W})$$

$$\text{avec } W = C2.C5.(C3 + C4).(C6 + C8)$$

Un filtre passe-bas LP1 s'obtient, comme représenté sur la figure 4b, en appliquant le signal à filtrer $V_{in}$ sur la connexion P5 et en recueillant le signal filtré $V_{out}$ sur la connexion P1, les connexions P2, P3, P4 et P6 étant reliées à la terre.

La fonction de transfert de ce filtre passe-bas est égale à:

$$F_{LP1}(z) = \frac{N_{LP1}(z)}{D(z)}$$

où $N_{LP1}(z) = -z^{-2} \cdot C4 \cdot C6 \cdot C7 \cdot C8/W$

Un filtre passe-haut HP s'obtient, comme représenté sur la figure 4c, en appliquant le signal à filtré $V_{in}$ sur la connexion P6 et en recueillant le signal filtré $V_{out}$ sur la connexion P2, les connexions P1, P3, P4 et P5 étant reliées à la terre. La fonction de transfert de ce filtre est définie par :

$$F_{HP}(z) = \frac{N_{HP}(z)}{D(z)}$$

où $N_{HP}(z) = -(1-z^{-1})^2 \cdot C6/C5$

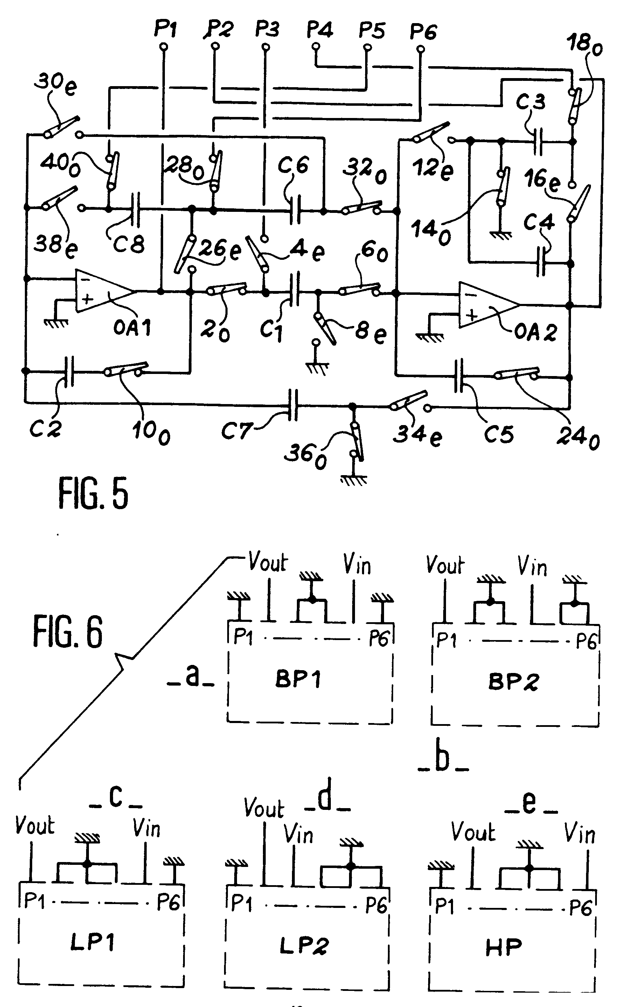

On a représenté sur la figure 5 une cellule biquadratique correspondant à une seconde configuration de cellule biquadratique de la figure 1. La cellule biquadratique de la figure 5 s'obtient en commandant les commutateurs 46, 48, 50 et 52 de la figure 1 de manière à relier les noeuds N1, N2, N3 et N4 à la terre.

Sur la figure 5, les éléments identiques à ceux de la figure 1 portent les mêmes références. Les interrupteurs 20e et $22_o$ de la figure 1 sont respectivement confondus, sur la figure 5, avec les interrupteurs 12e et 14o.

Selon les connexions choisies pour l'entrée et la sortie du signal, la cellule biquadratique de la figure 5 constitue un filtre passe-bande, un filtre passe-bas, ou un filtre passe-haut. Des exemples de filtres sont représentés schématiquement sur les figures 6a à 6e.

La cellule biquadratique de la figure 5 permet d'obtenir les filtres décrits en référence aux figures 4a, 4b et 4c obtenus à partir de la cellule biquadratique de la figure 3. Ainsi, les figures 6a, 6c et 6e montrent comment obtenir respectivement le filtre passe-bande BP1, le filtre passe-bas LP1 et le filtre passe-haut HP ; les connexions pour l'obtention de ces filtres sont identiques à celles décrites en référence aux figures 4a, 4b et 4c.

La cellule biquadratique de la figure 5 peut être également connectée de manière à former un second filtre passe-bande BP2. Les connexions sont représentées sur la figure 6b : le signal à filtrer est reçu sur la connexion P4 et le signal filtré recueilli sur la connexion P1, les connexions P2, P3, P5 et P6 étant reliées à la terre. La fonction de transfert de ce filtre est définie par :

$$F_{BP2}(z) = \frac{N_{BP2}(z)}{D(z)}$$

où $N_{BP2}(z) = z^{-1} (1-z^{-1}) C3.C7.C5(C6+C8)/W$

La cellule biquadratique de la figure 5 peut être également connectée pour former un second filtre passe-bas LP2. Les connexions pour l'obtention de ce filtre sont représentées sur la figure 6d : le signal à filtrer est reçu sur la connexion P3 et le signal filtré est recueilli sur la connexion P2, les connexions P1, P4, P5 et P6 étant reliées à la terre. La fonction de transfert de ce filtre est définie par :

$$F_{LP2}(z) = \frac{N_{LP2}(z)}{D(z)}$$

où $N_{LP2}(z) = -(1-z^{-1})^2 \cdot C6/C5$

La cellule biquadratique représentée sur la figure 5 présente la propriété d'être peu sensible au ratio de capacité et de bonnes performances en ce qui concerne la capacité totale des condensateurs.

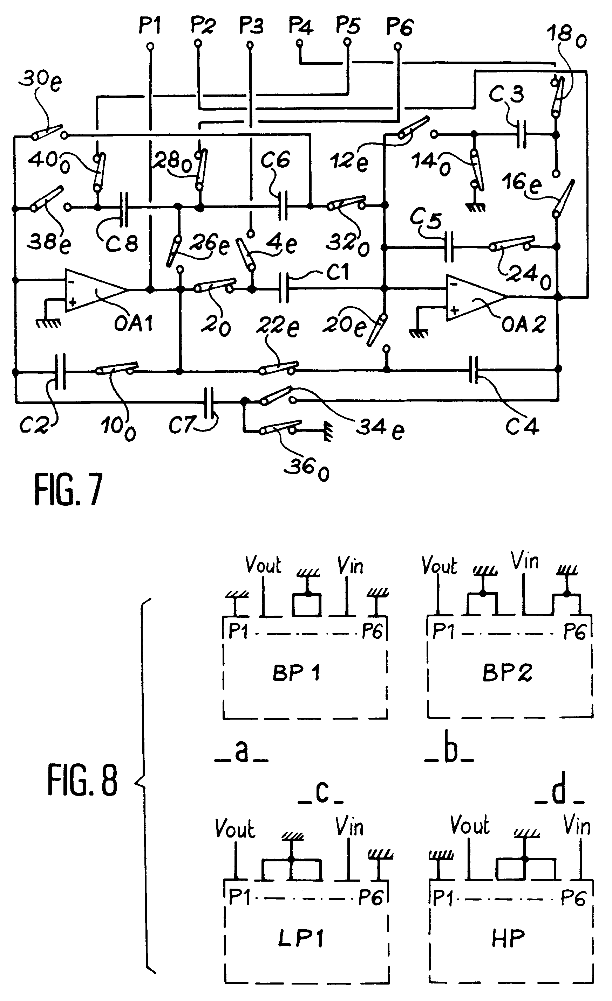

On a représenté sur la figure 7 une troisième cellule biquadratique correspondant à une configuration particulière de la cellule biquadratique de la figure 1. La cellule biquadratique représentée sur la figure 7 correspond à la cellule biquadratique représentée sur la figure 1 dans laquelle le noeud N1 est relié à l'entrée inverseuse de l'amplificateur opérationnel OA2, le noeud N2 est relié à la terre, le noeud N3 est relié à la sortie de l'amplificateur opérationnel OA1 et le noeud N4 est relié à la terre. Les interrupteurs $6_o$ et $8_e$ sont ainsi en parallèle, ce qui permet une connexion permanente du condensateur C1 à l'entrée inverseuse de l'amplificateur opérationnel OA2.

La cellule biquadratique représentée sur la figure 7 constitue un compromis, du point de vue de la sensibilité au gain des amplificateurs opérationnels et au ratio de capacité, par rapport aux cellules biquadratiques représentées sur les figures 3 et 5.

Selon les connexions choisies pour l'entrée et la sortie du signal, la cellule biquadratique de la figure 7 permet d'obtenir le filtre passe-bande BP1, le filtre passe-bande BP2, le filtre passe-bas LP1 et le filtre passe-haut HP. Les connexions à réaliser pour l'obtention de ces filtres sont représentées sur les figures 8a à 8d. Ces connexions sont respectivement identiques à celles illustrées sur les figures 6a, 6b, 6c et 6e.

Pour chacune des figures représentées sur les figures 3, 5 et 7, le demandeur a analysé l'effet du gain fini des amplificateurs opérationnels sur le facteur de surtension Q, et sur la pulsation $\omega_o$ correspondant à la fréquence centrale $f_0$ du signal à traiter. Ces paramètres sont définis par la relation suivante :

$$\omega_o \cdot T_s = \frac{C1 \cdot C4 \cdot C7}{C2 \cdot C5 \cdot (C3 + C4)}$$

$$Q = \frac{C6 + C8}{C6} \cdot \sqrt{\frac{C1 \cdot C5 \cdot (C3 + C4)}{C2 \cdot C7 \cdot C4}}$$

où $T_s$ est la période du signal d'horloge de commande des interrupteurs.

Le tableau 1 montre les erreurs relatives sur les paramètres Q et $\omega_0$, pour différentes valeurs des condensateurs, avec des amplificateurs opérationnels ayant un gain égal à 50 et pour des valeurs nominales Q = 16 et $\omega_o T_s$=0,25.

Dans ce tableau 1, $\eta$ représente le rapport entre la capacité du plus grand condensateur et la capacité du plus petit condensateur et $\Sigma C$ représente la somme des capacités des condensateurs, sans les condensateurs auxiliaires $C_x$ et et $C_y$ représentés sur la figure 2. A titre d'exemple, les capacités des condensateurs pour $\Sigma C$ = 34, ont pour valeur relative :
C1 = C4 = 5; C3 = C6 = C7 = 1; C2 = 5,5; C5 = 12; C8 = 3,5.

TABLEAU 1

| $\eta$ | 7 | | 7 | | 10 | | 12 | | 20 | | 30,5 | |
|---|---|---|---|---|---|---|---|---|---|---|---|---|
| $\sum c$ | 18 | | 22,1 | | 26,4 | | 34** | | 55 | | 84,5 | |
| erreurs relatives | $\frac{\Delta\omega_0}{\omega_0}$ [%] | $\frac{\Delta Q}{Q}$ [%] | $\frac{\Delta\omega_0}{\omega_0}$ [%] | $\frac{\Delta Q}{Q}$ [%] | $\frac{\Delta\omega_0}{\omega_0}$ [%] | $\frac{\Delta Q}{Q}$ [%] | $\frac{\Delta\omega_0}{\omega_0}$ [%] | $\frac{\Delta Q}{Q}$ [%] | $\frac{\Delta\omega_0}{\omega_0}$ [%] | $\frac{\Delta Q}{Q}$ [%] | $\frac{\Delta\omega_0}{\omega_0}$ [%] | $\frac{\Delta Q}{Q}$ [%] |
| Cellule biquad. selon fig.3 | 2,12 | 62,6 | 2,34 | 50,8 | 2,46 | 44,4 | 2,65 | 38,0 | 2,91 | 29,1 | 3,1 | 23,1 |
| Cellule biquad. selon fig.5 | 3,44 | 51,8 | 3,4 | 40,8 | 3,49 | 35,4 | 3,59 | 28,8 | 3,8 | 20,9 | 4,0 | 15,6 |
| Cellule biquad. selon fig.7 | 3,90 | 55,2 | 3,74 | 48,2 | 3,72 | 45,4 | 3,74 | 45,9 | 3,89 | 47,8 | 4,1 | 49,3 |

EP 0 308 287 B1

Le tableau 1 ci-dessus met en évidence les propriétés différentes des cellules biquadratiques représentées sur les figures 3, 5 et 7. Les cellules biquadratiques des figures 3 et 5 présentent, pour une même capacité totale, des erreurs relatives plus faibles que la cellule biquadratique de la figure 7. La cellule biquadratique de la figure 5 présente la plus petite erreur relative sur la surtension, pour une capacité totale égale à 84,5, mais en revanche l'erreur sur $\omega_0$ est importante. A l'inverse, la cellule biquadratique représentée sur la figure 3 présente la plus petite erreur relative sur $\omega_0$, pour une capacité totale de 18, mais l'erreur relative sur la surtension Q est alors plus importante.

Cependant, ces résultats ne sont pas significatifs en eux-mêmes et doivent être comparés avec ceux correspondant à des cellules biquadratiques connues.

A titre d'exemple, la cellule biquadratique représentée sur la figure 1b de l'article A2 présente les erreurs suivantes :

$\Delta\omega_0/\omega_0 = 2,76$ %,
$\Delta Q/Q = 48,12$ %,

pour une capacité totale $\Sigma C = 23,1$.

De même, la cellule biquadratique représentée sur la figure 5 de l'article A6 présente les erreurs relatives suivantes :

$\Delta\omega_0/\omega_0 = 2,26$ %,
$\Delta Q/Q = 88,43$ %,

pour une capacité totale égale à $\Sigma C = 29,95$.

On constate ainsi que la cellule biquadratique de la figure 3, pour laquelle la capacité totale est de 26,4 ou 18, présente des erreurs relatives sur Q et $\omega_0$ inférieures à celles des cellules biquadratiques connues.

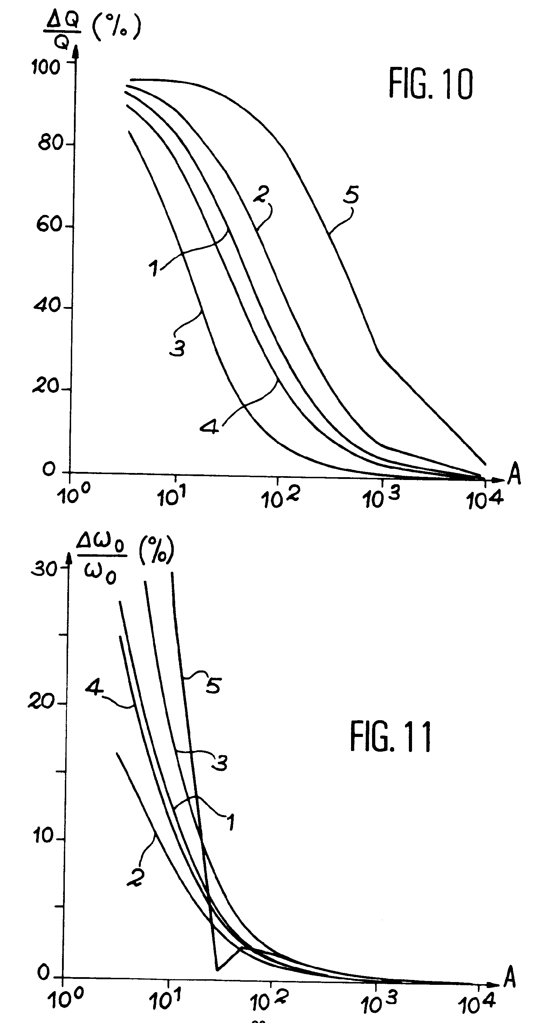

L'influence du gain des amplificateurs opérationnels sur le comportement des cellules biquadratiques est représentée sur les figures 9 à 11. Sur ces figures, on a représenté respectivement le facteur de surtension Q, l'erreur relative sur le facteur de surtension $\Delta Q/Q$ et l'erreur relative sur $\Delta\omega_0/\omega_0$ en fonction du gain de l'amplificateur. Sur chacun de ces graphiques, on a représenté cinq courbes correspondant aux cellules biquadratiques indiquées dans le tableau 2.

TABLEAU 2

| COURBE | CELLULE BIQUADRATIQUE | $\Sigma C$ | $\eta$ |
|--------|----------------------|------------|--------|
| 1 | Article A2 : fig. 1b | 23,1 | 8,1 |
| 2 | Invention : fig. 3 | 18 | 7 |
| 3 | Invention : fig. 5 | 84,5 | 30,5 |
| 4 | Invention : fig. 3 | 34 | 12 |
| 5 | Article A6 : fig.5 | 29,95 | 4 |

ANNEXE

Documents cités dans la description

A1 : G. Fisher, G.S. Moschytz, SC filters for high frequencies with compensation for finite-gain amplifiers, IEEE Trans. CAS, vol.32, Oct. 1985, pp. 1050-1056.

A2 : P.E. Fleicher, K.R. Laker, A Family of active switched capacitor biquad building blocks, The bell Syst. Tech. J., vol.58, Dec. 1979, pp. 2235-2268.

A3 : K. Haug. F. Maloberti, G.C. Temes, Switched-capacitor integrators with low finite-gain sensitivity, Electr. Lett., 21st Nov., vol.21, 1985, pp. 1156-1157.

A4 : K. Nagaraj, K. Singhal, T.R. Viswanathan, Y. Vlach, Reduction of finite-gain effect in switched-capacitor filters, Electr. Lett. 18th July 1985, vol.21, 1985, pp.644-645.

A5 : K. Nagaraj, J. Vlach, T.R. Viswanathan, K. Singhal switched-capacitor integrator with reduced sensitivity to amplifier gain, Electr., Lett., 9th October 1986, vol.22, n°21, pp.1103-1105.

A6 : A.E. Said, M.E. Zaghloul, Stray-free switched-capacitor general biquad blocks, IEE Proc. Pt-G, vol.133, June 1986, pp.154-158.
A7 : K.R. Laker, P.E. Fleischer, A. Ganesan, Parasitic insensitive, biphase switched capacitor filters realised with one operational amplifier per pole pair. The Bell Syst. Tech., vol.61, (5), 1982, pp.685-707.

**Revendications**

1. Cellule biquadratique à capacités commutées comprenant six connexions d'entrée-sortie P1, P2, ..., P6, et une entrée d'horloge H pour recevoir un signal d'horloge pour commander la fermeture et l'ouverture d'un ensemble d'interrupteurs, lesdits interrupteurs comprenant une première famille d'interrupteurs qui sont commandés dans l'état ouvert pendant une première demi-période de chaque période du signal d'horloge et qui sont commandés dans l'état fermé pendant une seconde demi-période de chaque période du signal d'horloge, et une seconde famille d'interrupteurs qui sont commandés dans l'état fermé pendant ladite première demi-période de chaque période du signal d'horloge et dans l'état fermé pendant ladite seconde demi-période de chaque période du signal d'horloge, ladite cellule biquadratique étant caractérisée en ce qu'elle comprend :
    – un premier amplificateur opérationnel OA1 muni d'une entrée non inverseuse reliée à la terre, d'une entrée inverseuse E1, et d'une sortie inverseuse S1 reliée à la première connexion P1 du filtre,
    – un second amplificateur opérationnel OA2 muni d'une entrée non-inverseuse reliée à la terre, d'une entrée inverseuse E2, et d'une sortie S2 reliée à la deuxième connexion P2 du filtre,
    – un premier condensateur C1 et des interrupteurs pour connecter ledit condensateur entre la sortie S1 du premier amplificateur opérationnel et l'entrée E2 du second amplificateur opérationnel pendant lesdites premières demi-périodes du signal d'horloge, et pour connecter ledit condensateur à la connexion P3 et à un noeud N1 pendant lesdites secondes demi-périodes du signal d'horloge,
    – un deuxième condensateur C2 et des interrupteurs pour connecter ledit condensateur entre l'entrée E1 et la sortie S1 du premier amplificateur opérationnel pendant lesdites premières demi-périodes du signal d'horloge, et pour connecter ledit condensateur uniquement à l'entrée E1 du premier amplificateur opérationnel pendant lesdites secondes demi-périodes du signal d'horloge,
    – un troisième condensateur C3 et des interrupteurs pour connecter ledit condensateur entre un noeud N2 et la connexion P4 pendant lesdites premières demi-périodes du signal d'horloge, et pour connecter ledit condensateur entre l'entrée E2 et la sortie S2 du second amplificateur opérationnel pendant lesdites secondes demi-périodes du signal d'horloge,
    – un quatrième condensateur C4 et des interrupteurs pour connecter ledit condensateur entre un noeud N3 et la sortie S2 du second amplificateur opérationnel pendant lesdites premières demi-périodes du signal d'horloge, et pour connecter ledit condensateur entre l'entrée E2 et la sortie S2 du second amplificateur opérationnel pendant lesdites secondes demi-périodes du signal d'horloge,
    – un cinquième condensateur C5 et des interrupteurs pour connecter ledit condensateur entre l'entrée E2 et la sortie S2 du second amplificateur opérationnel pendant lesdites premières demi-périodes du signal d'horloge, et pour connecter ledit condensateur uniquement à l'entrée E2 du second amplificateur opérationnel pendant lesdites secondes demi-périodes du signal d'horloge,
    – un sixième condensateur C6 et des interrupteurs pour connecter ledit condensateur entre la connexion P6 et l'entrée E2 du second amplificateur opérationnel pendant lesdites premières demi-périodes du signal d'horloge, et pour connecter ledit condensateur entre la sortie S1 et l'entrée E1 du premier amplificateur opérationnel pendant lesdites secondes demi-périodes du signal d'horloge,
    – un septième condensateur C7 et des interrupteurs pour connecter ledit condensateur entre l'entrée E1 du premier amplificateur opérationnel et un noeud N4 pendant lesdites premières demi-périodes du signal d'horloge, et pour connecter ledit condensateur entre l'entrée E1 du premier amplificateur opérationnel et la sortie S2 du second amplificateur opérationnel pendant lesdites secondes demi-périodes du signal d'horloge,
    – un huitième condensateur C8 et des interrupteurs pour connecter ledit condensateur entre les connexions P5 et P6 pendant lesdites premières demi-périodes du signal d'horloge, et pour connecter ledit condensateur entre l'entrée E1 et la sortie S1 du premier amplificateur opérationnel pendant lesdites secondes demi-périodes du signal d'horloge, et
    – quatre commutateurs à deux positions commandés par des signaux appliqués sur des bornes B1, B2, B3, B4 de la cellule biquadratrice, le premier commutateur étant disposé pour relier le noeud N1 à l'entrée E2 du second amplificateur opérationnel ou à la terre, le deuxième commutateur étant disposé pour relier le noeud N2 à l'entrée E2 du second amplificateur opérationnel ou à la terre, le troisième commutateur étant disposé pour relier le noeud N3 à la sortie S1 du premier amplificateur opérationnel ou à la terre, et le quatrième commutateur étant disposé pour relier le noeud N4 à l'entrée E2 du second amplificateur opérationnel ou à la terre.

2. Cellule biquadratique à capacités commutées selon la revendication 1, caractérisée en ce que des commutateurs sont commandés pour relier les noeuds N1, N2 et N4 à l'entrée inverseuse du second amplificateur opérationnel OA2 et le noeud N3 à la sortie du premier amplificateur opérationnel OA1.

3. Cellule biquadratique à capacités commutées selon la revendication 1, caractérisée en ce que les commutateurs sont commandés de manière à relier les noeuds N1, N2, N3 et N4 à la terre.

4. Cellule biquadratique à capacités commutées selon la revendication 1, caractérisée en ce que les commutateurs sont commandés de manière à relier le noeud N1 à l'entrée inverseuse de l'amplificateur opérationnel OA2, le noeud N3 à la sortie de lamplificateur opérationnel OA1 et les noeuds N2, N4 à la terre.

5. Cellule biquadratique à capacités commutées selon l'une quelconque des revendications 2 à 4, pour former un filtre passe-bande, caractérisée en ce que les connexions d'entrée et de sortie du filtre sont respectivement les connexions P5 et P2, les connexions P1, P3, P4 et P6 étant reliées à la terre.

6. Cellule biquadratique à capacités commutées selon l'une quelconque des revendications 3 et 4 pour former un filtre passe-bande, caractérisée en ce que les connexions d'entrée et de sortie du filtre sont respectivement les connexions P4 et P1, les connexions P2, P3, P5 et P6 étant reliées à la terre.

7. Cellule biquadratique à capacités commutées selon l'une quelconque des revendications 2 à 4 pour former un filtre passe-bas, caractérisée en ce que les connexions d'entrée et de sortie du filtre sont constituées respectivement par les connexions P5 et P1, les connexions P2, P3, P4 et P6 étant reliées à la terre.

8. Cellule biquadratique à capacités commutées selon la revendication 3 pour former un filtre passe-bas, caractérisée en ce que les connexions d'entrée et de sortie du filtre sont constituées respectivement par les connexions P3 et P2, les connexions P1, P4, P5 et P6 étant reliées à la terre.

9. Cellule biquadratique à capacités commutées selon l'une quelconque des revendications 2 à 4 pour former un filtre passe-haut, caractérisée en ce que les connexions d'entrée et de sortie du filtre sont constituées respectivement par les connexions P6 et P2, les connexions P1, P3, P4 et P5 étant reliées à la terre.

10. Cellule biquadratique à capacités commutées selon l'une quelconque des revendications 1 à 9, caractérisée en ce que chaque amplificateur opérationnel comporte une boucle continue de contreréaction comprenant deux condensateurs de faible capacité $C_x$ et $C_y$ connectés en série, un interrupteur de la première famille d'interrupteurs et un interrupteur de la seconde famille d'interrupteurs disposés chacun entre le point commun des condensateurs $C_x$ et $C_y$ et la terre.

**Patentansprüche**

1. Biquadratisches Element mit geschalteten Kapazitäten mit sechs Eingangs-Ausgangsverbindungen P1, P2, ..., P6 und einem Takteingang H, um ein Taktsignal zu empfangen, um das schließen und Öffnen einer schalteranordnung zu steuern, wobei die schalter eine erste Familie von schaltern, die während eines ersten Halbzyklus des Taktsignals in den geöffneten Zustand geschaltet werden und die während eines zweiten Halbzyklus des Taktsignals in den geschlossenen Zustand geschaltet werden, und eine zweite Familie von Schaltern umfaßt, die während eines ersten Halbzyklus des Taktsignals in den geschlossenen Zustand geschaltet werden und die während eines zweiten Halbzyklus des Taktsignals in den geöffneten Zustand geschaltet werden, wobei dieses biquadratische Element dadurch gekennzeichnet ist, daß es umfaßt:

– einen ersten Operationsverstärker OA1, der mit einem nicht invertierenden Eingang, der mit der Erde verbunden ist, einem invertierenden Eingang EI und einem invertierenden Ausgang S1 versehen ist, der mit dem ersten Anschluß P1 des Filters verbunden ist,

– einen zweiten Operationsverstärker OA2, der mit einem nicht invertierenden Eingang, der mit der Erde verbunden ist, einem invertierenden Eingang E2 und einem Ausgang S2 versehen ist, der mit dem zweiten Anschluß P2 des Filters verbunden ist,

– einen ersten Kondensator C1 und schalter zum Verbinden des Kondensators zwischen dem Ausgang S1 des ersten Operationsverstärkers und dem Eingang E2 des zweiten Operationsverstärkers während der ersten Halbzyklen des Taktsignals und zum Verbinden des Kondensators mit dem Anschluß P3 und mit einem Knoten N1 während der zweiten Halbzyklen des Taktsignals,

– einen zweiten Kondensator C2 und schalter zum Verbinden des Kondensators zwischen dem Eingang E1 und dem Ausgang S1 des ersten Operationsverstärkers während der ersten Halbzyklen des Taktsignals und zum Verbinden des Kondensators lediglich mit dem Eingang E1 des ersten Operationsverstärkers während der zweiten Halbzyklen des Taktsignals,

– einen dritten Kondensator C3 und Schalter zum Verbinden des Kondensators zwischen einen Knoten N2 und dem Anschluß P4 während der ersten Halbzyklen des Taktsignals und zum Verbinden des Kondensators zwischen dem Eingang E2 und dem Ausgang S2 des zweiten Operationsverstärkers während der zweiten Halbzyklen des Taktsignals,

– einen vierten Kondensator C4 und schalter zum Verbinden des Kondensators zwischen einem Knoten N3 und dem Ausgang S2 des zweiten Operationsverstärkers während der ersten Halbzyklen des Taktsignals und zum Verbinden des Kondensators zwischen dem Eingang E2 und dem Ausgang S2 des zweiten Operationsverstärkers während der zweiten Halbzyklen des Taktsignals,

– einen fünften Kondensator C5 und Schalter zum Verbinden des Kondensators zwischen dem Eingang E2 und dem Ausgang S2 des zweiten Operationsverstärkers während der ersten Halbzyklen des Taktsignals und zum Verbinden des Kondensators lediglich mit dem Eingang E2 des zweiten Operationsverstärkers während der zweiten Halbzyklen des Taktsignals,

– einen sechsten Kondensator C6 und schalter zum Verbinden des Kondensators zwischen dem Anschluß P6 und dem Eingang E2 des zweiten Operationsverstärkers während der ersten Halbzyklen des Taktsignals und zum Verbinden des Kondensators mit dem Ausgang S1 und dem Eingang EI des ersten Operationsverstärkers während der zweiten Halbzyklen des Taktsignals,

– einen siebten Kondensator C7 und schalter zum Verbinden des Kondensators zwischen dem Eingang EI des ersten Operationsverstärkers und einem Knoten N4 während der ersten Halbzyklen des Taktsignals und zum Verbinden des Kondensators zwischen dem Eingang EI des ersten Operationsverstärkers und dem Ausgang S2 des zweiten Operationsverstärkers während der zweiten Halbzyklen des Taktsignals,

– einen achten Kondensator C7 und schalter zum Verbinden des Kondensators zwischen dem Ausgang S1 den Anschlüssen P5 und P6 während der ersten Halbzyklen des Taktsignals und zum Verbinden des Kondensators zwischen dem Eingang E1 und dem Ausgang S1 des ersten Operationsverstärkers während der zweiten Halbzyklen des Taktsignals,

– vier Zweipositionsschalter, die von signalen geschaltet werden, die an Anschlüsse B1, B2, B3, B4 des biquadratischen Elements angelegt werden, wobei der erste Schalter so angeordnet ist, daß er den Knoten N1 mit dem Eingang E2 des zweiten Operationsverstärkers oder mit der Erde verbindet, der zweite schalter so angeordnet ist, daß er den Knoten N2 mit dem Eingang E2 des zweiten Operationsverstärkers oder mit der Erde verbindet, der dritte schalter so angeordnet ist, daß er den Knoten N3 mit dem Ausgangs S1 des ersten Operationsverstärkers oder mit der Erde verbindet, und der vierte schalter so angeordnet ist, daß er den Knoten N4 mit dem Eingang E2 des zweiten Operationsverstärkers oder mit der Erde verbindet.

2. Biquadratisches Element mit geschalteten Kapazitäten nach Anspruch 1, dadurch gekennzeichnet, daß Schalter geschaltet werden, um die Knoten N1, N2 und N4 mit dem invertierenden Eingang der Zweiten Operationsverstärkers OA2 und den Knoten N3 mit dem Ausgang des ersten Operationsverstärkers OA1 zu verbinden.

3. Biquadratisches Element mit geschalteten Kapazitäten nach Anspruch 1, dadurch gekennzeichnet, daß die schalter derart geschaltet werden, daß die Knoten N1, N2, N3 und N4 mit der Erde verbunden werden.

4. Biquadratisches Element mit geschalteten Kapazitäten nach Anspruch 1, dadurch gekennzeichnet, daß die schalter derart geschaltet werden, daß der Knoten N1 mit dem invertierenden Eingang des Operationsverstärkers OA2, der Knoten N3 mit dem Ausgang des Operationsverstärkers OA1 und die Knoten N2, N4 mit der Erde verbunden werden.

5. Biquadratisches Element mit geschalteten Kapazitäten nach einem der Ansprüche 2 bis 4 zum Bilden eines Bandpaßfilters, dadurch gekennzeichnet, daß die Eingangs- und Ausgangsanschlüsse des Filters jeweils die Anschlüsse P5 und P2 sind, wobei die Anschlüsse P1, P3, P4 und P6 mit der Erde verbunden sind.

6. Biquadratisches Element mit geschalteten Kapazitäten nach einem der Ansprüche 2 bis 4 zum Bilden eines Bandpaßfilters, dadurch gekennzeichnet, daß die Eingangs- und Ausgangsanschlüsse des Filters jeweils die Anschlüsse P4 und P1 sind, wobei die Anschlüsse P2, P3, P4 und P6 mit der Erde verbunden sind.

7. Biquadratisches Element mit geschalteten Kapazitäten nach einem der Ansprüche 2 bis 4 zum Bilden eines Tiefpaßfilters, dadurch gekennzeichnet, daß die Eingangs- und Ausgangsanschlüsse des Filters jeweils die Anschlüsse P5 und P1 sind, wobei die Anschüsse P2, P3, P4 und P6 mit der Erde verbunden sind.

8. Biquadratisches Element mit geschalteten Kapazitäten nach Anspruch 3 zum Bilden eines Tiefpaßfilters, dadurch gekennzeichnet, daß die Eingangs- und Ausgangsanschlüsse des Filters jeweils die Anschlüsse P3 und P2 sind, wobei die Anschlüsse P1, P4, P5 und P6 mit der Erde verbunden sind.

9. Biquadratisches Element mit geschalteten Kapazitäten nach einem der Ansprüche 2 bis 4 zum Bilden eines Hochpaßfilters, dadurch gekennzeichnet, daß die Eingangs- und Ausgangsanschlüsse des Filters jeweils die Anschlüsse P6 und P2 sind, wobei die Anschlüsse P1, P3, P4 und P5 mit der Erde verbunden sind.

10. Biquadratisches Element mit geschalteten Kapazitäten nach einem der Ansprüche 1 bis 9, dadurch gekennzeichnet, daß jeder Operationsverstärker eine kontinuierliche Gegenreaktionsschleife besitzt, die zwei Kondensatoren geringer Kapazität $C_x$ und $C_y$ die in Reihe geschaltet sind, einen schalter der ersten schalterfamilie und einen schalter der zweiten schalterfamilie umfaßt, die jeweils zwischen dem gemeinsamen Punkt der Kondensatoren $C_x$ und $C_y$ und der Erde angeschlossen sind.

## Claims

1. Switched capacitor biquad block incorporating six input-output connections P1, P2, ..., P6 and a clock input H for receiving a clock signal for controlling the closing and opening of a group of switches, said switches comprising a first family of switches controlled in the open state during a first half-cycle of each cycle of the clock signal and which are controlled in the closed state during a second half-cycle of each cycle of the clock signal and a second family of switches controlled in the closed state during said first half-cycle of each cycle of the clock signal and in the open state during said second half-cycle of each cycle of the clock signal, said biquad block comprising:

– a first operational amplifier OA1 provided with a non-inverting input connected to earth, an inverting input E1 and an inverting output S1 connected to the first connection P1 of the filter,

– a second operational amplifier OA2 provided with a non-inverting input connected to earth, an inverting input E2 and an output S2 connected to the second connection P2 of the filter,

– a first capacitor C1 and switches for connecting said capacitor between the output S1 of the first operational amplifier and the input E2 of the second operational amplifier during said first half-cycles of the clock signal and for connecting said capacitor to the connection P3 and to a node N1 during said second half-cycles of the clock signal,

– a second capacitor C2 and switches for connecting said capacitor between the input E1 and theoutput S1 of the first operational amplifier during said first half-cycles of the clock signal and for connecting said capacitor solely to the input E1 of the first operational amplifier during said second half-cycles of the clock signal,

– a third capacitor C3 and switches for connecting said capacitor between a node N2 and connection P4 during said first half-cycles of the clock signal and for connecting said capacitor between the input E2 and the output S2 of the second operational amplifier during said second half-cycles of the clock signal,

– a fourth capacitor C4 and switches for connecting said capacitor between a node N3 and the output S2 of the second operational amplifier during said first half-cycles of the clock signal and for connecting said capacitor between the input E2 and the output S2 of the second operational amplifier during said second half-cycles . of the clock signal,

– a fifth capacitor C5 and switches for connecting said capacitor between input E2 and output S2 of the second operational amplifier during said first half-cycles of the clock signal and for connecting said capacitor solely to the input E2 of the second operational amplifier during said second half-cycles of the clock signal,

– a sixth capacitor C6 and switches for connecting said capacitor between connection P6 and input E2 of the second operational amplifier during said first half-cycles of the clock signal and for connecting said capacitor between output S1 and input E1 of the first operational amplifier during said second half-cycles of the clock signal,

– a seventh capacitor C7 and switches for connecting said capacitor between input E1 of the first operational amplifier and a node N4 during said first half-cycles of the clock signal and for connecting said capacitor between input E1 of the first operational amplifier and output S2 of the second operational amplifier during said second half-cycles of the clock signal,

– an eighth capacitor C8 and switches for correcting said capacitor between connections P5 and P6 during said first half-cycles of the clock signal and for connecting said capacitor between input E1 and output S1 of the first operational amplifier during said second half-cycles of the clock signal, and

– four two-position switches controlled by signals applied to terminals B1, B2, B3, B4 of the biquad block, the first switch connecting node N1 to input E2 of the second operational amplifier or to earth, the second switch connecting node N2 to input E2 of the second operational amplifier or to earth, the third switch connecting node N3 to output S1 of the first operational amplifier or to earth and the fourth switch for connecting node N4 to input E2 of the second operational amplifier or to earth.

2. Switched capacitor biquad block according to claim 1, characterized in that said switches are controlled for connecting the nodes N1, N2 and N4 to the inverting input of said second operational amplifier OA2 and node N3 to the output of the first operational amplifier OA1.

3. Switched capacitor biquad block according to claim 1, characterized in that said switches are controlled so as to connect nodes N1, N2, N3 and N4 to earth.

4. Switched capacitor biquad block according to claim 1, characterized in that said switches are controlled so as to connect node N1 to the inverting input of operational amplifier OA2, node N3 to the output of operational amplifier OA1 and nodes N2 and N4 to earth.

5. Switched capacitor biquad block according to any one of the claims 2 to 4 for forming a band-pass filter, characterized in that the input and output connections of the filter are respectively connections P5 and P2, connection P1, P3, P4 and P6 being connected to earth.

6. Switched capacitor biquad block according to either of the claims 3 and 4 for forming a band-pass filter, characterized in that the input and output connections of the filter are respectively connections P4 and P1, connections P2, P3, P5 and P6 being connected to earth.

7. Switched capacitor biquad block according to any one of the claims 2 to 4 for forming a low-pass filter, characterized in that the input and output connections of the filter are respectively constituted by connections P5 and P1, connections P2, P3, P4 and P6 being connected to earth.

8. Switched capacitor biquad block according to claim 3 for forming a low-pass filter, characterized in that the input and output connections of the filter are respectively constituted by connections P3 and P2, connections P1, P4, P5 and P6 being connected to earth.

9. Switched capacitor biquad block according to any one of the claims 2 to 4 for forming a high-pass filter, characterized in that the input and output connections of the filter are respectively constituted by connections P6 and P2, connections P1, P3, P4 and P5 being connected to earth.

10. Switched capacitor biquad block according to any one of the claims 1 to 9, characterized in that each operational amplifier has a continuous feedback loop comprising two low capacitance capacitors $C_x$ and $C_y$ connected in series, a switch of the first family of switches and a switch of the second family of switches each located between the common point of capacitors $C_x$ and $C_y$ and earth.

FIG. 1

15

FIG. 2

FIG 9

FIG. 3

FIG. 4

_a_

BP 1

_b_

LP 1

_c_

HP

B. 9435

FIG. 5

FIG. 6

FIG. 7

FIG. 8

_a_  _b_  _c_  _d_

FIG. 10

FIG. 11